# EUROPEAN PATENT SPECIFICATION

(11) **EP 4 152 589 B1**
(45) Date of publication and mention of the grant of the patent: **24.07.2024**
(21) Application number: 21461595.7
(22) Date of filing: 21.09.2021
(51) Int. Cl.: H02N 2/18

(54) **PHOTO-PIEZOELECTRIC GENERATOR OF ELECTRICAL ENERGY FROM LIGHT ENERGY**
PHOTO-PIEZOELEKTRISCHER GENERATOR VON ELEKTRISCHER ENERGIE AUS LICHTENERGIE
GÉNÉRATEUR PHOTO-PIÉZOÉLECTRIQUE D'ÉNERGIE ÉLECTRIQUE À PARTIR D'ÉNERGIE LUMINEUSE

(43) Date of publication of application: 22.03.2023
(73) Proprietor: Centrum Badan i Rozwoju Technologii dla Przemyslu S.A., 00-645 Warszawa (PL); Italian National Council of Research - CNR, 00185 Roma (IT); Agenzia Nazionale per le Nuove Tecnologie, l'Energia e Lo Sviluppo Economico Sostenibile, 00196 Roma (IT); Université Grenoble Alpes, 38058 Grenoble Cedex 9 (FR)
(72) Inventor: Haras, Maciej, Warszawa (PL); Skotnicki, Tomasz, Warszawa (PL); Wlazlo, Mateusz, Warszawa (PL); Kolodziej, Grzegorz, Warszawa (PL); Petti, Lucia, Roma (IT); Nenna, Giuseppe, Roma (IT); Ardila-Rodriguez, Gustavo, Grenoble (FR)
(74) Representative: Kancelaria Eupatent.pl Sp. z.o.o

(56) References cited:
- CN-A- 108 809 208
- CN-A- 109 428 515
- KR-B1- 101 928 966
- US-A1- 2019 187 456

## Description

### TECHNICAL FIELD

The present invention relates to generation of electrical energy from light energy by means of a photo-piezoelectric generator.

### BACKGROUND

There are known photo-piezoelectric electronic elements comprising a piezoelectric material attached to a polymer layer. They can be used as switches, sensors, energy generators etc. Such devices, when illuminated, generate voltage on their terminals. Operation of these elements depends on properties of a photo-mobile polymer material, which allows for conversion of light energy into mechanical energy. When illuminated, the photo-mobile polymer layer is deformed, e.g. by bending or twisting, which causes deformation of the piezoelectric layer attached to the photo-mobile layer. As a result, a difference of voltage potentials is generated on the terminals of the piezoelectric material, therefore electrical energy is generated.

For example, PCT application WO2019202620A1 discloses an energy conversion device configured to convert a light signal into an electrical signal, comprising: a substantially planar actuator element, having at least one activatable portion, said activatable portion comprising a photomobile polymeric material; a substantially planar transducer element, having at least a portion of piezoelectric material; wherein said actuator element is coupled to said transducer element so that, at a light beam incident on said photomobile polymeric material, a movement of said transducer element is activated through a movement of said activatable portion, said movement of said transducer element providing the generation of a potential difference at the terminal ends of said portion of piezoelectric material. Such device has a drawback that upon illumination of the layer containing the photo-mobile polymer it will bend only once and remain in the bent position until the illumination vanishes. It means that when placed under constant illumination, the device will produce only a single portion of energy by generating a single electrical pulse.

US2019187456 discloses a modulating retroreflective multilayer film comprising retroreflective elements, a piezoelectric layer, a photovoltaic layer, and an energy storage device. The stacked and transparent layered configuration of the film allows the retroreflective elements and the photovoltaic layer to be simultaneously illuminated by a narrow beam. The low power piezoelectric layer and the energy harvesting of the photovoltaic layer allow the retroreflector to be energetically self-sufficient and suitable for remote deployment. The flexible properties of the component layers allow the retroreflector to be adhered to nonplanar or irregular surfaces for the purpose of labeling and tagging.

KR101928966B1 discloses a multi-smart sensor device using multiple inputs of energy harvesting. The technical problem to be solved is to produce and collect electric energy based on photoelectric effect generated by light energy, piezoelectric effect by vibration, electromagnetic induction phenomenon by magnetic field change, improve reliability by multi-sensing, and increase the versatility of use through multiple sensors. According to an embodiment, the multi-smart sensor device includes an energy harvesting unit that produces energy based on a photoelectric effect using light energy, a piezoelectric effect associated with external force, and electromagnetic induction; a power source unit for storing and supplying energy produced through the energy harvesting unit; a sensor unit for detecting a mechanical contact, a contact by magnetic field and metal, and a posture by positional change, respectively; and a communication interface unit for transmitting detected data of the sensor unit to an external receiving apparatus.

CN108809208B discloses a road energy collection device, which includes a base, a photovoltaic power generation module and a piezoelectric power generation module; the photovoltaic power generation module is installed on the surface of the base and is used to collect road light to generate electricity.

CN109428515A discloses a miniature composite vibration generator that comprises a base, a shell arranged on the base and a thin film piezoelectric piece arranged in the shell, and further comprises a solar photovoltaic cell arranged on the upper surface of the shell, a circuit board arranged in the shell, and a U-shaped mass block connected with thethin film piezoelectric piece.

### SUMMARY OF THE INVENTION

Therefore, there is a need to provide a photo-piezoelectric generator that sustains its operation under constant illumination.

The object of the invention is a photo-piezoelectric generator of electrical energy from light energy according to the appended claims.

Since the converting element is adapted to perform cyclic deformation, in can operate in a sustained manner under constant illumination of the generator. Therefore, the generator does not require use of devices that would cyclically turn illumination on and off, or cyclically cover and uncover the generator.

The elastic converting element may comprise a first layer made of a piezoelectric material and a second layer made of a photo-mobile polymer material attached thereto, wherein a first electrode layer is provided at one side of the first layer between the first layer and the second layer and a second electrode layer is provided at the other side of the first layer. Such structure of the elastic converting element is one of the possible solutions that allows its bending. The presence of two electrodes ensures the ability of electrical energy collection from the piezoelectric material layer.

The elastic converting element can be mounted at one side to the inner wall of the casing, wherein the casing is opaque; and a lens can be provided at one side of the casing, wherein the converting element is mounted such that incident light refracted by the lens illuminates a larger area of the second layer made of the photo-mobile polymer in the first position than in the second position of the converting element. It is one of the possible configurations of the generator that allows for cyclic bending of the converting element. The opaqueness of the casing ensures that the photo-sensitive second layer made of the photo-mobile polymer is subject only to the light that passes through the lens.

The inner walls of the casing can be covered by an antireflective material. This eliminates parasitic illumination of the converting element by light reflected from the inner walls. The light reflected from the inner walls might impede the dynamics and amplitude of bending of the converting element, and in the worst case - it might halt the cyclic operation.

The piezoelectric material of the first layer contains a material that exhibits piezoelectric properties, such as zinc oxide nanowires

The zinc oxide nanowires can be immersed in an electrical insulator. The advantage of using a nanostructured piezoelectric layer is the enhancement of generated piezoelectric signal compared to a bulk material. Preferably, the nanostructured layer has a morphology of nanowires with the highest possible height to width ratio, which maximizes the generated voltage. The most dense possible packing of nanowires per unit area, while maintaining electrical separation ensures by the insulator layer maximizes the generated current. Both strategies (nanostructring and dense packing) directly enhance the generated power.

The lens can be a biconvex focusing lens having a focal length selected so that the focal point of the lens lies on the second layer made of the photo-mobile polymer material when the converting element is in the first position. Placing the focal point on the layer made of a photo-mobile polymer material causes light energy to be focused on the photo-mobile polymer. Therefore, the photo-mobile polymer material is struck by higher density of electromagnetic radiation. This leads to increased amplitude and/or frequency of the bending of the converting element.

The converting element can be mounted in a plane that is perpendicular to the optical axis of the lens. The lens focuses incoming light beams. Therefore, in the first position, when the converting element is undeformed, it lies in the focal point O of the lens. After bending, the converting element lies essentially outside the focal point.

The converting element can be mounted in a plane that is oblique to the optical axis of the lens. Mounting the converting element at an oblique angle from the optical axis of the lens causes the incoming light to focus in the shape of an ellipse on the surface of the converting element. Consequently, the surface area of focus on the surface of the converting element is higher than in an embodiment in which the converting element is perpendicular to the optical axis of the lens. A larger surface area of focus causes faster isomerization of the photo-mobile material, which causes the bending of the converting element to be greater and more dynamic. Additionally, mounting the converting element at an oblique angle from the optical axis of the lens causes the converting element to cross from illuminated to dark region and back in a more rapid manner than in an embodiment in which the converting element is perpendicular to the optical axis of the lens.

The converting element can be rigidly and inseparably attached to the casing at its one end, while the other end of the converting element can be free. Rigid attachment of only one end of the converting element facilitates cyclic motion of the converting element between the illuminated and dark regions. Moreover, attaching only one end provides means to achieve higher bending of the other end of the converting element. Additionally, attaching only one side of the converting element minimizes the risk of the converting element halting in a midpoint between illuminated and dark regions.

The photo-mobile polymer material of the second layer may exhibits a delay between turning on the illumination and the beginning of the bending mechanical motion. The delay between illumination (the beginning of light energy absorption) and deformation ensure cyclic operation of the converting element. It prevents halting of the converting element in a midpoint between illuminated and dark regions.

The generator may further comprise a ferromagnetic mass attached to the free end of the converting element and a permanent magnet mounted on the casing such that the ferromagnetic mass interacts with the permanent magnet at a portion of the trajectory of the converting element. The permanent magnet and the ferromagnetic mass allows sustained operation of the generator in case the photo-mobile polymer material does not show intrinsic delay between illumination and deformation.

These and other features, aspects and advantages of the invention will become better understood with reference to the following drawings, descriptions and claims.

### BRIEF DESCRIPTION OF DRAWINGS

Various embodiments are herein described, by way of example only, with reference to the accompanying drawings, wherein:
Fig. 1 shows a photo-piezoelectric generator of electrical energy from light energy according to a first embodiment in a side view;
Figs. 2A-2F show, in a cross section A-A' of Fig. 1, subsequent steps of deformation of a converting element;
Fig. 3 shows the photo-piezoelectric generator of electrical energy from light energy according to a second embodiment in a side view;
Figs. 4A-4F show, in a cross section A-A' of Fig. 3, subsequent steps of deformation of a converting element;
Fig. 5 shows schematically a structure of the converting element;
Fig. 6 shows a waveform of generated voltage;
Fig. 7A shows a work cycle of the generator upon bending of the converting element;
Fig. 7B shows a trajectory of the converting element during the cyclic work of the generator;
Fig. 8 shows the photo-piezoelectric generator of electrical energy from light energy according to a third embodiment in a side view;
Figs. 9A-9F shows, in a cross-section A-A' of Fig. 8, subsequent steps of deformation of the converting element.

### DETAILED DESCRIPTION OF EMBODIMENTS

The following detailed description is not to be taken in a limiting sense, but is made merely for the purpose of illustrating the general principles of the invention.

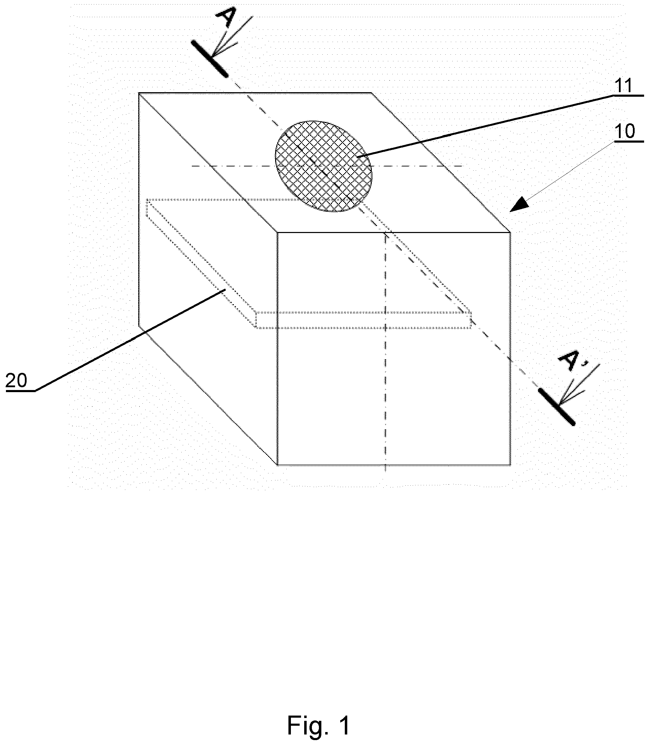

Fig. 1 shows a photo-piezoelectric generator of electrical energy from light energy according to a first embodiment in a side view. The photo-piezoelectric generator comprises an opaque casing 10 and an elastic converting element 20 positioned within the casing 10, mounted at one side to the wall of the casing 10. Additionally, one of the walls of the casing 10 contains a lens 11. Preferably, one end of the converting element 20 is rigidly and inseparably attached to the casing 10, while the other end of the converting element 20 is free. Preferably, in this first embodiment, the converting element 20 is mounted in a plane that is perpendicular to the optical axis of the lens 11. Preferably, the converting element 20 has a form a multilayer rectangular plate.

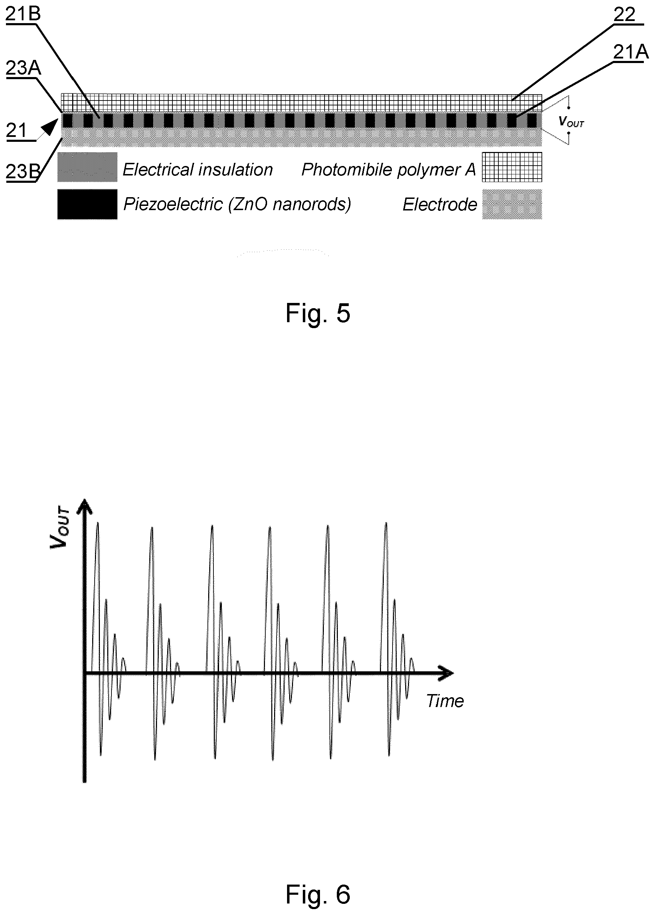

Fig. 5 shows schematically a structure the converting element 20. The converting element 20 comprises a first layer 21 made of a piezoelectric material, on top of which a second layer 22 made of a photo-mobile polymer material is provided. In addition, a first electrode layer 23A is provided at one side of the first layer 21 (between the first layer 21 and the second layer 22) and a second electrode layer 23B is provided on the other side of the first layer 21. The material of the first layer 21 can be any piezoelectric material including zinc oxide ZnO nanostructures, e.g. having a form of nanowires. Preferably, the first layer 21, between regions 21A which contain the piezoelectric material, comprises regions 21B made of an electrical insulator. Preferably, the piezoelectric components are immersed in an electrical insulator which allows for energy collection only from the top surface.

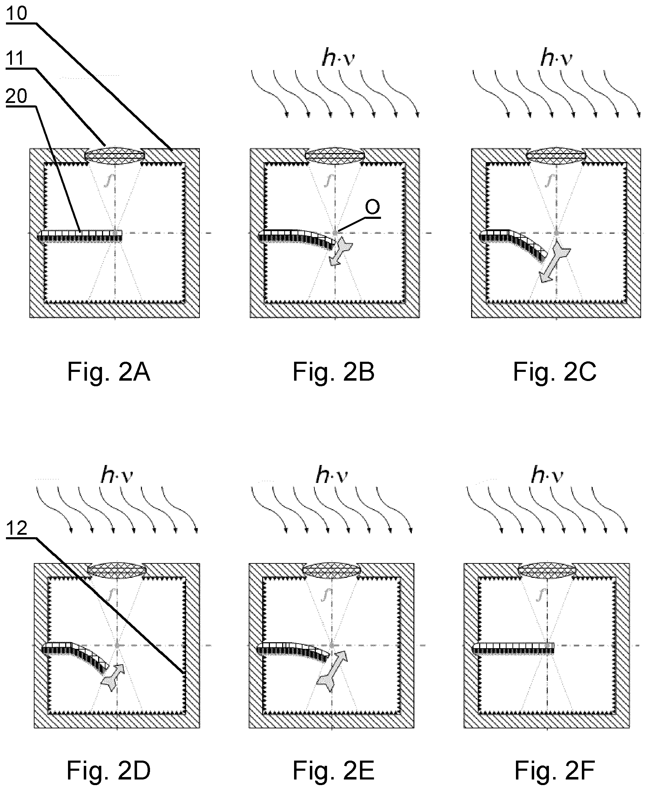

Figs. 2A-2F show, in a cross section A-A' of Fig. 1, subsequent steps of deformation of the converting element 20 between its first position and second position (wherein the first position can be considered as an initial position and the second position can be considered as a final position within one deformation stage). The converting element 20 is mounted on the casing 10 such that it can be deformed between the first position and the second position. In the first position incident light refracted by the lens 11 illuminates a larger area of the second layer 22 made of a photo-mobile polymer than it does in the second position. Preferably, the lens 11 is a biconvex focusing lens having a focal length f selected so that the focal point O of the lens 11 lies on the second layer 22 when the converting element 20 is in the first position and, preferably, the focal point O lies outside the second layer 22 when the converting element 20 is in the second position. Preferably, in the first position, the converting element 20 is essentially straight. Upon illumination with light beams striking the photo-mobile material, the second layer 22 deforms, in particular by bending, which causes bending of all the layers that constitute the converting element 20.

In other words, in the first position (i.e. in a resting state) as shown in Fig. 2A, the converting element 20 is essentially straight. When natural or artificial light carrying energy (hv per quantum) reaches the generator, it is focused by the lens 11 in the focal point O. The photo-mobile polymer in the second layer 22 interacts with the light, which after a finite period of illumination causes a mechanical stress which leads to a bending of the second layer 22, and thus the whole converting element 20. The bending results in a displacement of the converting element 20 to a less illuminated region of the casing 10, in particular beyond the focal point O of lens 11 (Fig. 2C). This leads to dissipation of an isomerization reaction in the photo-mobile polymer layer 22 and the movement of the converting element 20 (Figs. 2D, 2E) back to its straight position (Figs. 2F, 2A). In the straight position, the converting element 20 returns to the focal point O of the lens 11, wherein the light intensity is at its maximum and another work cycle can begin (Figs. 2D/4D/7D). The motion induced by light, depicted schematically in Figs. 2A-2F, is the source of bending of the first layer 21 made of the piezoelectric material, which induces a voltage V_{OUT} between electrodes 23A and 23B. Therefore, the generator according to the present invention utilizes the piezoelectric conversion of the cyclic mechanical bending of the photo-mobile polymer to convert light energy to mechanical energy, and in turn, to electrical energy. Fig. 6 shows a waveform of the generated voltage.

Preferably, the inner walls of the casing 10 are covered by an antireflective (or a light-absorbing) material 12. Consequently, light entering the interior of the casing 10 through the lens 11 is not reflected from the inner walls of the casing 10 and does not cause a secondary illumination of the converting element 20, which would lead to impeded dynamics of motion (i.e. slowing down) of the converting element 20, and consequently, halting the converting element 20 in an intermediate position. To prevent this from occurring, the converting element 20 is illuminated only by light entering the interior of the casing 10 through the lens 11, and not by light reflected from the inner walls of the casing 10.

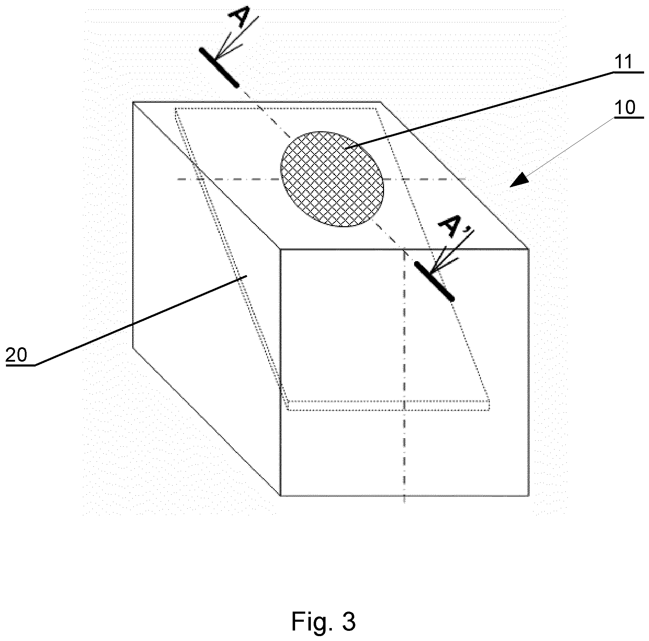

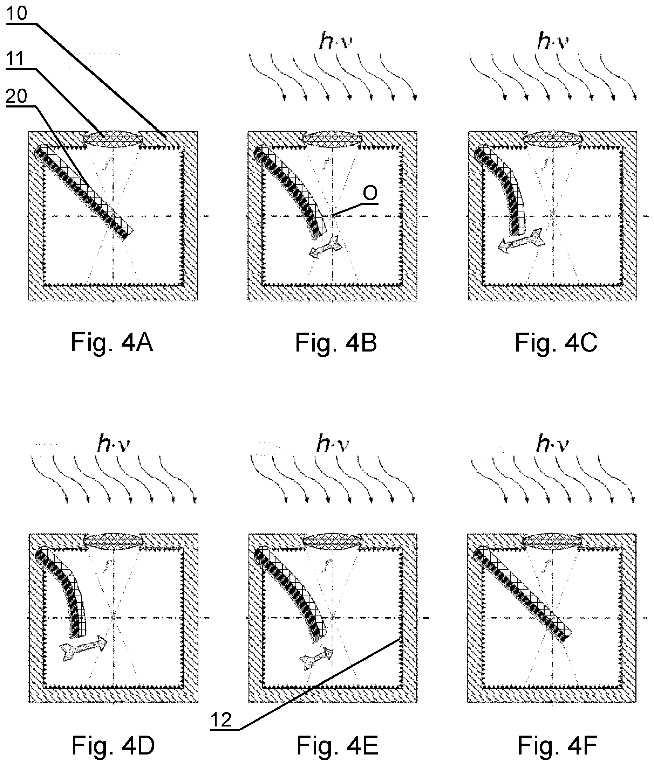

Fig. 3 shows a photo-piezoelectric generator of electrical energy from light energy according to a second embodiment in a side view. Figs. 4A-4F show, in a cross section A-A' of Fig. 3, subsequent steps of deformation of the converting element 20. In the second embodiment, the converting element 20 is mounted in a plane that is oblique to the optical axis of the lens 11. Therefore, incident light refracted by the lens 11 illuminates a larger area of the second layer 22 and delivers more energy to this layer than it would otherwise. Additionally, the motion of the converting element 20 leads to a more rapid exiting and subsequent entering of the second layer 22 made of the photo-mobile polymer to the focal area of the lens 11. Therefore, the converting element 20 can bend with an increased amplitude and frequency, which causes more energy to be generated. Preferably, in the second embodiment, the converting element 20 is mounted at an oblique angle with respect the focal axis of the lens 11. Preferably, one end of the converting element 20 is rigidly and inseparably attached to the casing 10, while the other end of the converting element 20 is free. In the second embodiment, similarly to the first embodiment, the converting element 20 is mounted on the casing 10 such that it can be deformed between the first position and the second position, while in the first position the incident light refracted by the lens 11 illuminates a larger area of the second layer 22 made of the photo-mobile polymer than it does in the second position. Preferably, the lens 11 is a biconvex focusing lens having a focal length f selected so that the focal point O of the lens 11 lies on the second layer 22 when the converting element 20 is in the first position and, preferably, the focal point O lies outside the second layer 22 (or even outside the converting element 20) when the converting element 20 is in the second position. Preferably, in the first position, the converting element 20 is essentially straight. Upon illumination with light beams striking the photo-mobile material, the second layer 22 deforms, in particular by bending, which causes the bending of all the layers that constitute the converting element 20.

The photo-piezoelectric generator of electrical energy from light energy according to present invention allows cyclic bending of the converting element 20 under constant illumination with artificial or natural light. Additionally, the use of an antireflective/light-absorbing coating 12 on the inner walls of the casing 10 reduces the negative effect of light reflected from the inner walls of the casing 10, increasing the amplitude and/or frequency of bending of the converting element 20. In the second embodiment, mounting the converting element 20 at an oblique angle to the optical axis of the lens 11 increases the area of the illuminated surface. Additionally the converting element 20 exits/enters the focal point O of the lens 11 more rapidly. Therefore, the amplitude and/or frequency of bending is even higher, which in turn enhances the electrical energy yield. Additionally, depending on the dimensions of the lens 11, the width and length of the converting element 20 can be scaled in order to optimize the energy yield.

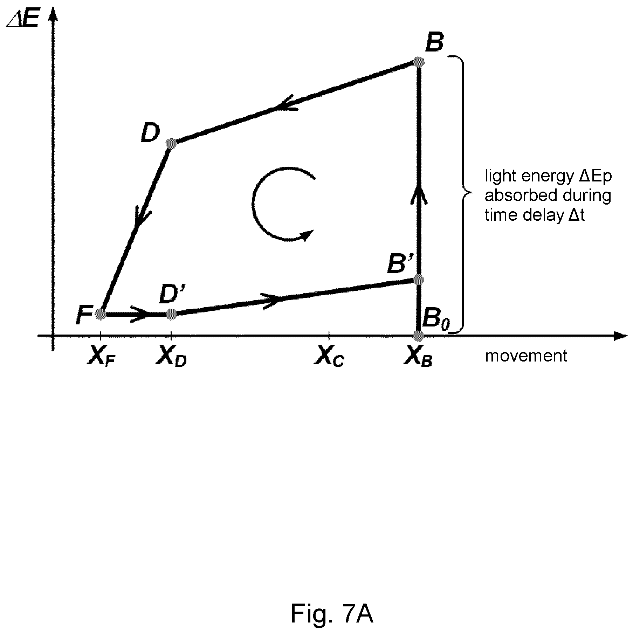

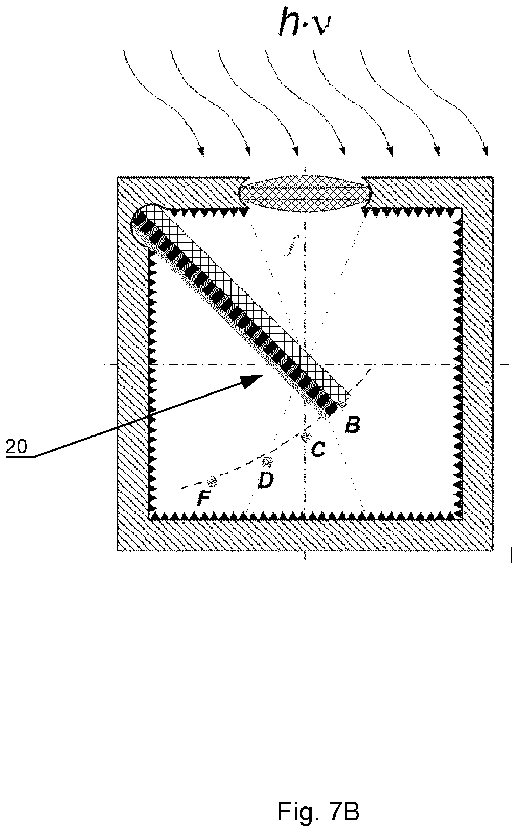

The embodiments of the photo-piezoelectric generator of electrical energy from light energy shown in Fig. 2 and Fig. 4 will continue to work in cyclic and non-interrupted manner under constant illumination as long as there is a delay between absorption of light by the photo-mobile polymer 22 and its mechanical motion. In other words, the photo-mobile polymer 22 should accumulate light energy and after a period of time it should start bending while being able to perform a short motion even under no illumination or weak illumination. Fig. 7A shows a work cycle of the generator according to present invention upon bending of the converting element 20 on the trajectory shown in Fig. 7B.

The motion of the converting element 20 is shown in Fig. 7B, wherein:
- point *B* is the initial position;
- upon illumination, the converting element 20 moves in sequence through points *C, D,* and *F* (corresponding to a maximum displacement);
- in point *F,* the converting element 20 is not illuminated, therefore its motion is reversed and it moves in reverse order through points *D, C,* and ending at point *B;*
- in point *B,* the converting element 20 is illuminated again, therefore another work cycle can begin through the points *C, D,* and *F.*

Without the aforementioned delay between the illumination and the deformation, the converting element 20 would halt at a boundary between the illuminated and unilluminated regions (point D in Fig. 7B). In the opposite case, the conversion of light energy into motion occurs with a delay *Δt.* The inertness of the converting element 20 (that results from the accumulated kinetic Energy Eₖ) also allows for motion beyond point *D.* However, the mass of the converting element 20 is low, and its speed between points *B→F* and *F→B* is low, and therefore Eₖ may be not sufficient to move the converting element 20 beyond point D and towards point *F.*

If some light energy (*ΔE*), which had not been converted into displacement, remains accumulated in the photo-mobile polymer 22, then the motion of the converting element 20 between points *D→F* will be observed. In other words, when the converting element 20 is at point D and *ΔE>0,* then a force *F_{D→F}>0* appears, which causes the converting element 20 to move from point *D* to point *F.* In point *F,* the whole energy *ΔE* is utilized, and the elasticity of the converting element 20 forces its return back to point B.

The return to the initial point *B* is possible also because the delay between the light absorption and the motion. Otherwise, during the motion between points *F→B,* at point *D* a force will appear that will halt the movement of the converting element 20 and cause its premature movement back towards point *F,* without ever reaching point *B.* As a result, this would lead to a damped movement of the converting element 20 around point *D.* This delay causes the converting element 20 to reach point *B.* The stop at point *B* lasts for a period *Δt,* during which the photo-mobile polymer 22 accumulates light energy, which allows it to start a new work cycle - motion between points *B→F.*

Fig. 7A shows energetics of the work cycle of the generator upon bending of the converting element. The process begins at point *B0_{,}* displacement *x_{B},* and energy *E=0.* The motion begins after time *Δt,* during which the photo-mobile polymer 22 absorbs a threshold energy *ΔE_{P},* which initiates the motion of the converting element 20. On the section *B→D,* the photo-mobile polymer 22 continues to absorb light and convert it into motion. At point D, the photo-mobile polymer 22 still contains a portion of accumulated energy *ΔE>0,* but does not absorb any more light. The converting element 20 continues its motion to point F, losing it energy *ΔE*. Upon reaching point F, the movement to point D' begins due to the elasticity of the converting element 20. On the section *D*'→*B*', the polymer absorbs light energy, but the halting force does not appear, because the accumulated energy *ΔE>ΔE_{P}* (in other words, the section *D'→B'* lasts less than *Δt*). At point B', the photo-mobile polymer 22 absorbs energy. After reaching accumulated energy *ΔE_{P},* another work cycle begins.

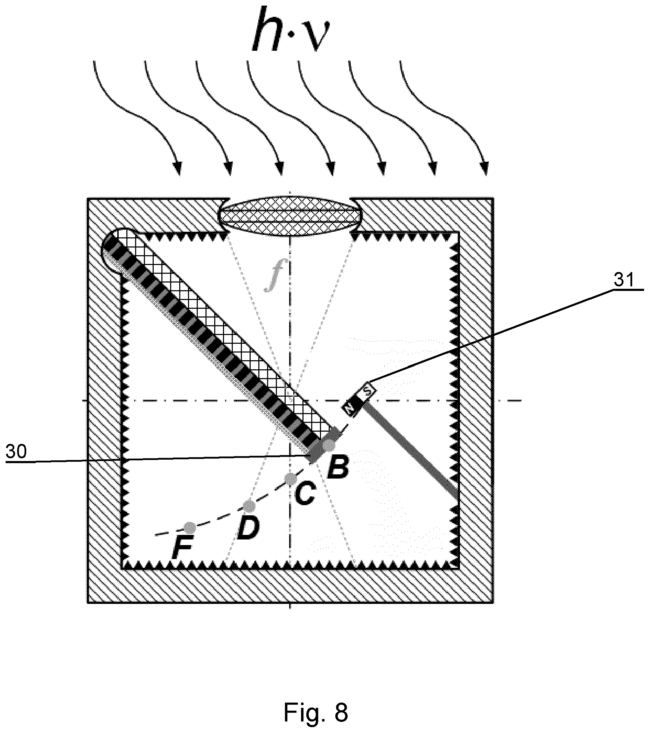

In case when the photo-mobile polymer 22 would not exhibit any delay between light absorption and motion, a damped movement around point *D* would occur with a decreasing amplitude. In the steady state, the converting element 20 would stop in point *D.* In order to prevent this, it should be ensured that the converting element 20 exhibits a delayed motion by using external elements. To achieve this, a permanent magnet and a ferromagnetic mass can be used. Fig. 8 shows the photo-piezoelectric generator of electrical energy from light energy according to a third embodiment, wherein the delay of the converting element 20 is ensured by external elements - a ferromagnetic mass 30 mounted on the free end of the converting element 20 and a permanent magnet 31 mounted on the casing 10.

The delay of motion on the section *B→C* can be achieved by placing the permanent magnet 31 and the ferromagnetic mass 30 in such a way that the converting element 20 halts its motion in point B until illumination appears. The appearance of illumination induces a driving force that induces the motion, but after a time period *Δt* which is needed for the driving force of the photo-mobile polymer 22 to exceed the attractive force of the permanent magnet 31.

The delay in point *D* (which causes the movement between points *D→F*) can be achieved by the ferromagnetic mass 30 which is mounted on the free end of the converting element 20. A properly selected mass 30 ensures that the converting element 20 has enough kinetic energy that once the driving force vanishes, it can cross the distance between points *D→F.* Simultaneously, the mass 30 cannot diminish the elasticity of the converting element 20 which would prevent it from crossing the distance between points *F→D.*

The ferromagnetic mass 30 enhances the return motion of the converting element 20. During the reverse motion form point F, the accumulated kinetic energy allows it to cross point *D,* in which the halting action of the driving force of the photo-mobile polymer 22 begins.

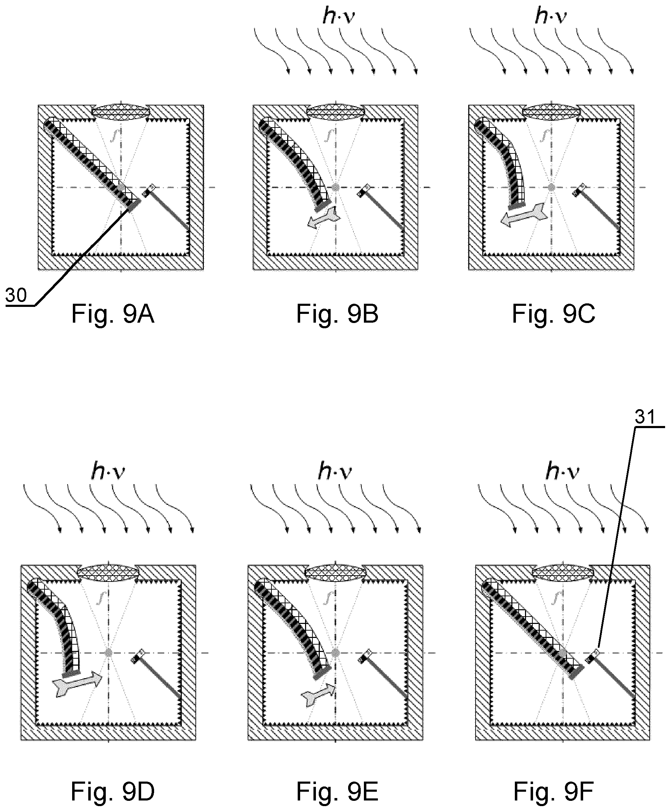

The attractive force of the permanent magnet 31 and the mass of the ferromagnetic object 30 have to be selected such as to maintain cyclic work. Together with the elastic deformation force of the photo-mobile polymer 22, the halting action of the driving force has to be overcome, which would allow for the converting element to return to point *B.* If the aforementioned condition is fulfilled, then the energy diagram is the same as depicted in Fig. 7A, even though the photo-mobile polymer 22 does not show the delay between light absorption and motion. Figs. 9A-9F show, in a cross section A-A' of Fig. 8, subsequent steps of deformation of the converting element, wherein the permanent magnet 31 and the ferromagnetic mass 30 allow for modified operation of the generator according to present invention in case the photo-mobile polymer material of the second layer 22 does not exhibit intrinsic delay between light absorption and motion.

While the invention has been described with respect to a limited number of embodiments, it will be appreciated that many variations, modifications and other applications of the invention may be made. Therefore, the claimed invention as recited in the claims that follow is not limited to the embodiments described herein, but solely by the appended claims.

## Claims

1. A photo-piezoelectric generator of electrical energy from light energy, the generator comprising a casing (10) and an elastic converting element (20) mounted within the casing, wherein said converting element (20) is configured to cyclically deform, due to being illuminated by light, between a first position and a second position while the generator is under constant illumination by light energy.

2. The generator according to claim 1, wherein the elastic converting element (20) comprises a first layer (21) made of a piezoelectric material and a second layer (22) made of a photo-mobile polymer material attached thereto, wherein a first electrode layer (23A) is provided at one side of the first layer (21) between the first layer (21) and the second layer (22) and a second electrode layer (23B) is provided at the other side of the first layer (21).

3. The generator according to any of previous claims, wherein:
- the elastic converting element (20) is mounted at one side to the inner wall of the casing (10), wherein the casing (10) is opaque;
- a lens (11) is provided at one side of the casing, wherein the converting element (20) is mounted such that incident light refracted by the lens (11) illuminates a larger area of the second layer (22) made of the photo-mobile polymer in the first position than in the second position of the converting element (20).

4. The generator according to any of previous claims, wherein the inner walls of the casing (10) are covered by an antireflective material (12).

5. The generator according to any claims 2 - 4, wherein the piezoelectric material of the first layer (21) contains a material that exhibits piezoelectric properties, such as zinc oxide (ZnO) nanowires (21A).

6. The generator according to claim 5, wherein the zinc oxide (ZnO) nanowires (21A) are immersed in an electrical insulator (21B).

7. The generator according to any of claims 3-6, wherein the lens (11) is a biconvex focusing lens having a focal length (f) selected so that the focal point of the lens (11) lies on the second layer (22) made of the photo-mobile polymer material when the converting element (20) is in the first position.

8. The generator according to any of claims 3 - 7, wherein the converting element (20) is mounted in a plane that is perpendicular to the optical axis of the lens (11).

9. The generator according to any of claims 3 - 7, wherein the converting element (20) is mounted in a plane that is oblique to the optical axis of the lens (11).

10. The generator according to any of previous claims, wherein the converting element (20) is rigidly and inseparably attached to the casing (10) at its one end, while the other end of the converting element (20) is free.

11. The generator according to any of claims 2 - 10, wherein the photo-mobile polymer material of the second layer (22) exhibits a delay (Δ*t*) between turning on the illumination and the beginning of the bending mechanical motion.

12. The generator according to any of claims 3 - 10, further comprising a ferromagnetic mass (30) attached to the free end of the converting element (20) and a permanent magnet (31) mounted on the casing (10) such that the ferromagnetic mass (30) interacts with the permanent magnet (31) at a portion of the trajectory of the converting element (20).

## Patentansprüche

1. Photo-piezoelektrischer Generator von elektrischer Energie aus Lichtenergie, wobei der Generator ein Gehäuse (10) und ein innerhalb des Gehäuses montiertes elastisches Umwandlungselement (20) umfasst, wobei das Umwandlungselement (20) so konfiguriert ist, dass es sich aufgrund dessen, dass es durch Licht beleuchtet wird, zyklisch zwischen einer ersten Position und einer zweiten Position verformt, während sich der Generator unter konstanter Beleuchtung durch Lichtenergie befindet.

2. Generator nach Anspruch 1, wobei das elastische Umwandlungselement (20) eine erste Schicht (21) aus einem piezoelektrischen Material und eine daran angebrachte zweite Schicht (22) aus einem photomobilen Polymermaterial umfasst, wobei zwischen der ersten Schicht (21) und der zweiten Schicht (22) auf einer Seite der ersten Schicht (21) eine erste Elektrodenschicht (23A) vorgesehen ist und auf der anderen Seite der ersten Schicht (21) eine zweite Elektrodenschicht (23B) vorgesehen ist.

3. Generator nach einem der vorhergehenden Ansprüche, wobei:
- das elastische Umwandlungselement (20) auf einer Seite an der Innenwand des Gehäuses (10) montiert ist, wobei das Gehäuse (10) undurchsichtig ist;
- an einer Seite des Gehäuses eine Linse (11) vorgesehen ist, wobei das Umwandlungselement (20) so montiert ist, dass von der Linse (11) gebrochenes einfallendes Licht einen größeren Bereich der zweiten Schicht (22) aus dem fotomobilen Polymer in der ersten Position als in der zweiten Position des Umwandlungselements (20) beleuchtet.

4. Generator nach einem der vorhergehenden Ansprüche, wobei die Innenwände des Gehäuses (10) mit einem Antireflexmaterial (12) bedeckt sind.

5. Generator nach einem der Ansprüche 2 bis 4, wobei das piezoelektrische Material der ersten Schicht (21) ein Material enthält, das piezoelektrische Eigenschaften aufweist, wie etwa Nanodrähte (21A) aus Zinkoxid (ZnO).

6. Generator nach Anspruch 5, wobei die Nanodrähte (21A) aus Zinkoxid (ZnO) in einen elektrischen Isolator (21B) eingetaucht sind.

7. Generator nach einem der Ansprüche 3 bis 6, wobei die Linse (11) eine bikonvexe Fokussierlinse mit einer Brennweite (/) ist, die so gewählt ist, dass der Brennpunkt der Linse (11) auf der zweiten Schicht (22) aus dem photomobilen Polymermaterial liegt, wenn sich das Umwandlungselement (20) in der ersten Position befindet.

8. Generator nach einem der Ansprüche 3 bis 7, wobei das Umwandlungselement (20) in einer Ebene montiert ist, die senkrecht zur optischen Achse der Linse (11) verläuft.

9. Generator nach einem der Ansprüche 3 bis 7, wobei das Umwandlungselement (20) in einer Ebene montiert ist, die schräg zur optischen Achse der Linse (11) verläuft.

10. Generator nach einem der vorhergehenden Ansprüche, wobei das Umwandlungselement (20) an seinem einen Ende starr und untrennbar am Gehäuse (10) angebracht ist, während das andere Ende des Umwandlungselements (20) frei ist.

11. Generator nach einem der Ansprüche 2 bis 10, wobei das photomobile Polymermaterial der zweiten Schicht (22) eine Verzögerung (Δt) zwischen dem Einschalten der Beleuchtung und dem Beginn der mechanischen Biegebewegung aufweist.

12. Generator nach einem der Ansprüche 3 bis 10, ferner umfassend eine ferromagnetische Masse (30), die an dem freien Ende des Umwandlungselements (20) angebracht ist, und einen Permanentmagneten (31), der an dem Gehäuse (10) so montiert ist, dass sich die ferromagnetische Masse (30) mit dem Permanentmagneten (31) an einem Abschnitt der Trajektorie des Umwandlungselements (20) gegenseitig beeinflusst.

## Revendications

1. Générateur photopiézoélectrique d'énergie électrique à partir d'énergie lumineuse, le générateur comprenant un boîtier (10) et un élément de conversion élastique (20) monté à l'intérieur du boîtier, dans lequel ledit élément de conversion (20) est configuré pour se déformer cycliquement, en raison de son éclairage par la lumière, entre une première position et une seconde position tandis que le générateur est sous un éclairage constant par l'énergie lumineuse.

2. Générateur selon la revendication 1, dans lequel l'élément de conversion élastique (20) comprend une première couche (21) constituée d'un matériau piézoélectrique et une seconde couche (22) constituée d'un matériau polymère photomobile fixée à celle-ci, dans lequel une première couche d'électrode (23A) est prévue sur un côté de la première couche (21) entre la première couche (21) et la seconde couche (22) et une seconde couche d'électrode (23B) est prévue sur l'autre côté de la première couche (21).

3. Générateur selon l'une quelconque des revendications précédentes, dans lequel :
- l'élément de conversion élastique (20) est monté sur un côté sur la paroi interne du boîtier (10), dans lequel le boîtier (10) est opaque ;
- une lentille (11) est prévue sur un côté du boîtier, dans lequel l'élément de conversion (20) est monté de telle sorte que la lumière incidente réfractée par la lentille (11) éclaire une zone plus grande de la seconde couche (22) constituée du polymère photo-mobile dans la première position que dans la seconde position de l'élément de conversion (20).

4. Générateur selon l'une quelconque des revendications précédentes, dans lequel les parois internes du boîtier (10) sont recouvertes d'un matériau antireflet (12).

5. Générateur selon l'une quelconque des revendications 2 à 4, dans lequel le matériau piézoélectrique de la première couche (21) contient un matériau qui présente des propriétés piézoélectriques, tel que des nanofils d'oxyde de zinc (ZnO) (21A).

6. Générateur selon la revendication 5, dans lequel les nanofils d'oxyde de zinc (ZnO) (21A) sont immergés dans un isolant électrique (21B).

7. Générateur selon l'une quelconque des revendications 3 à 6, dans lequel la lentille (11) est une lentille de focalisation biconvexe ayant une distance focale (j) sélectionnée de telle sorte que le foyer de la lentille (11) repose sur la seconde couche (22) constituée du matériau polymère photo-mobile lorsque l'élément de conversion (20) est dans la première position.

8. Générateur selon l'une quelconque des revendications 3 à 7, dans lequel l'élément de conversion (20) est monté dans un plan qui est perpendiculaire à l'axe optique de la lentille (11).

9. Générateur selon l'une quelconque des revendications 3 à 7, dans lequel l'élément de conversion (20) est monté dans un plan qui est oblique par rapport à l'axe optique de la lentille (11).

10. Générateur selon l'une quelconque des revendications précédentes, dans lequel l'élément de conversion (20) est fixé de manière rigide et inséparable au boîtier (10) au niveau d'une de ses extrémités, tandis que l'autre extrémité de l'élément de conversion (20) est libre.

11. Générateur selon l'une quelconque des revendications 2 à 10, dans lequel le matériau polymère photo-mobile de la seconde couche (22) présente un délai (Δt) entre l'allumage de l'éclairage et le début du mouvement mécanique de flexion.

12. Générateur selon l'une quelconque des revendications 3 à 10, comprenant en outre une masse ferromagnétique (30) fixée à l'extrémité libre de l'élément de conversion (20) et un aimant permanent (31) monté sur le boîtier (10) de telle sorte que la masse ferromagnétique (30) interagisse avec l'aimant permanent (31) au niveau d'une partie de la trajectoire de l'élément de conversion (20).
